# EUROPEAN PATENT APPLICATION

(11) **EP 0 768 212 A2**
(43) Date of publication of application: **16.04.1997**
(21) Application number: 96202628.2
(22) Date of filing: 19.09.1996
(51) Int. Cl.: B60R 16/02

(54) **Control module**

(30) Priority: 12.10.1995 GB 9520865; 17.01.1996 GB 9600914
(71) Applicant: GENERAL MOTORS CORPORATION, Detroit Michigan 48202 (US)
(72) Inventor: Lahier, Gilbert, L-8379 Kleinbettingen (LU)
(74) Representative: Denton, Michael John

(57) **Abstract**

A control module (10) for a radiator fan comprising a housing (12); a thick film circuit (20) at least partially covered by the housing and having at least one resistor formed thereon; a number of relays (24) covered by the housing; electrical circuitry means (22) covered by the housing and electrically interconnecting the resistors and the relays; heat dissipating means (30); and electrical connectors (26) for providing input power to the electrical circuitry means and for providing control signals to the radiator fan. Reduces wiring complexity.

## Description

The present invention relates to a control module for housing control elements for controlling the operation of a radiator fan in a motor vehicle.

It is known to provide a radiator in the engine cooling system of a motor vehicle. A fan is used to blow cooling air across the radiator. A control system switches the fan on and off, and also runs the fan at one of a number of pre-set speeds, dependent on the temperature of the radiator and monitored pressures within an air conditioning system (when present). This known control system includes a number of relays and resistors positioned at various locations within the cooling system. The relays switch on power to the fan motor and the resistors in a number of predetermined configurations to obtain the required speed for the fan. The scattered location of the relays and resistors results in complex wiring for the control system.

It is an object of the present invention to overcome the above disadvantage.

A control module in accordance with the present invention for a radiator fan comprises a housing; a thick film circuit at least partially covered by the housing and having at least one resistor formed thereon; a number of relays covered by the housing; electrical circuitry means covered by the housing and electrically interconnecting the resistors and the relays; heat dissipating means; and electrical connectors for providing input power to the electrical circuitry means and for providing control signals to the radiator fan.

The present invention houses all the control system components for the radiator fan within a single housing, thereby reducing wiring complexity.

The present invention will now be described, by way of example, with reference to the accompanying drawings, in which:-
Figure 1 is an exploded view of a control module in accordance with the present invention;
Figure 2 is an exploded view of a second embodiment of control module in accordance with the present invention;
Figure 3 is top view of a combined thick film circuit and electrical circuitry means, relays, resistors, and electrical connectors which can be used with the control module of Figure 2;
Figure 4 is a circuit diagram of the control module of Figure 2 with associated motors and sensors;
Figure 5 is a side view of an alternative arrangement of housing and heat sink for the embodiment shown in Figure 2;
Figure 6 is an exploded view of a third embodiment of control module in accordance with the present invention;
Figure 7 is a side view, partially in cross-section, of a fourth embodiment of control module in accordance with the present invention; and
Figure 8 is a top view, partially cut away, of a fifth embodiment of control module in accordance with the present invention

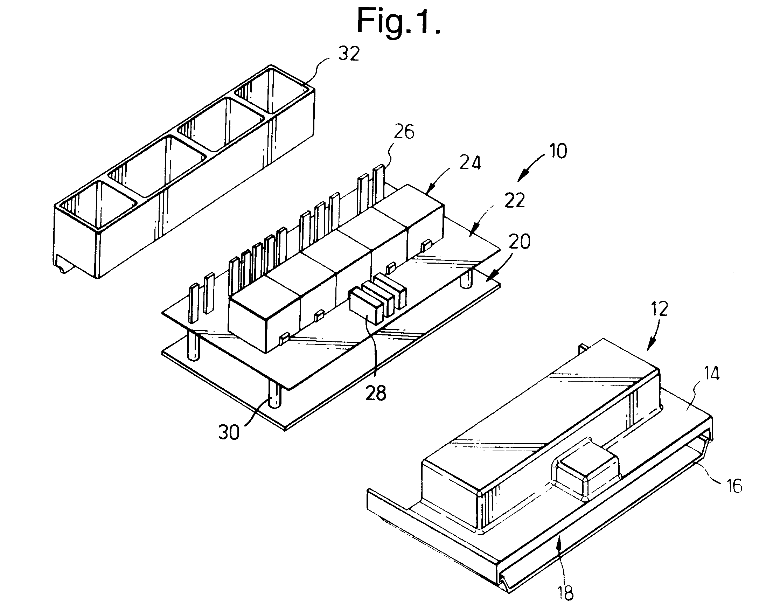

Referring to Figure 1 of the drawings, the control module 10 comprises a housing 12 of plastics material which may be moulded in one piece, or in two pieces 14, 16, as shown, which snap fit together or are otherwise secured together. The housing 12 has a duct 18 therethrough for the passage of cooling air. The control module 10 further comprises a thick film circuit 20 with at least one resistor and connecting tracks formed thereon. The thick film circuit 20 is preferably formed from alumina board onto which the resistors have been deposited. A printed circuit board (PCB) 22 having electrical interconnections and components thereon defines electrical circuitry means for the control module 10. Mounted on the PCB 22 are a number of relays 24, electrical connectors 26, and, optionally, fuses 28. Substantially rigid metallic posts 30 interconnect the PCB 22 with the thick film circuit 20. The posts 30 provide the electrical connection between the PCB 22 and the resistors on the thick film circuit 20, and act as heat dissipating means for the control module 10. A connector housing 32 may surround the electrical connectors 26. The connector housing 32 may be separately formed as shown and secured to the housing 12, or may be formed integrally with the housing 12. On assembly of the control module 10, the housing 12 substantially surrounds the thick film circuit 20, the PCB 22, the relays 24 and the fuses 28.

In use, one or more of the electrical connectors 26 provide input power (for example, from a vehicle battery, not shown) to the control module 10. One or more of the electrical connectors 26 is connected to one or more temperature sensors (not shown) mounted on the radiator (not shown) of a motor vehicle to provide an input signal to the control module. Where the motor vehicle has an air conditioning system (not shown), one or more of the electrical connectors 26 may be connected to one or more pressure sensors (not shown) in the air conditioning system. One or more of the electrical connectors 26 provides output power to one or more motors (not shown) of the radiator fan (not shown) from the control module 10. The electrical circuitry means of the PCB 22 monitors the signal from the temperature sensor (and the pressure sensors, where present) and actuates the relays 24 in a predetermined sequence to connect the resistors in a predetermined layout. The connection layout of the resistors determines the output power delivered to a radiator fan motor, and hence the speed of the radiator fan.

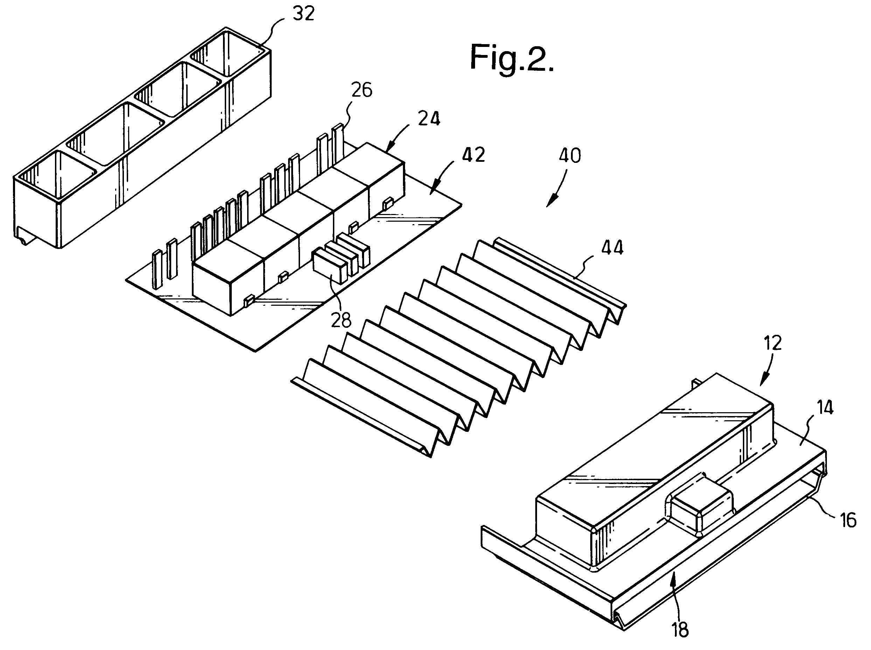

The second embodiment of control module 40 shown in Figure 2 is similar to the control module 10 of Figure 1, and like parts have been given the same reference numeral. In this embodiment, the thick film circuit and the electrical circuitry means are formed as a single element 42. The combined thick film circuit and electrical circuitry means 42 comprises a thick film board onto which the resistors and electrical interconnections have been deposited, onto which the components of the electrical circuitry means have been mounted, and onto which the relays 24, electrical connectors 26 and fuses 28 have also been mounted. On assembly, the combined element 42 is positioned against a heat dissipating means 44 in the form of a substantially corrugated heat sink. The control module 40 operates in substantially the same way as the control module 10 of Figure 1, as described above.

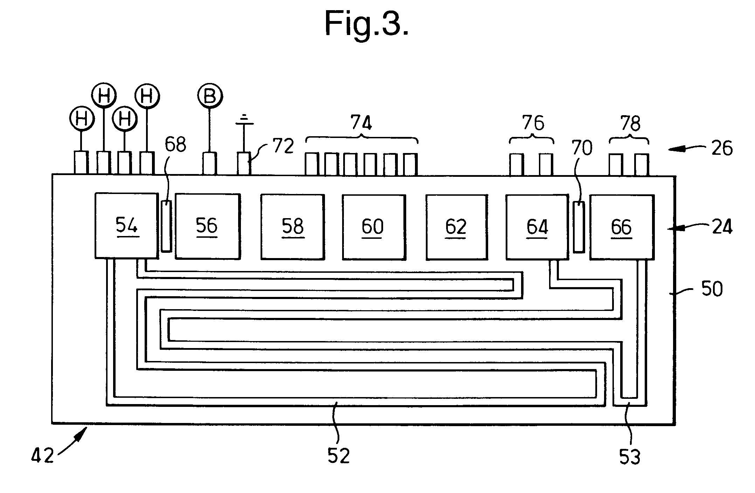

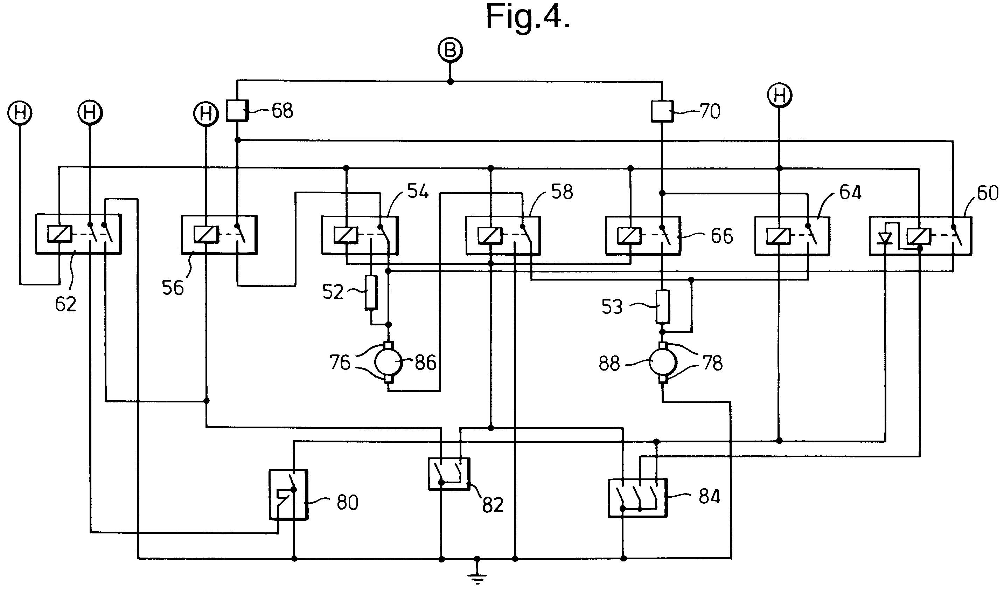

Figure 3 shows an example of the element 42 which comprises an alumina board 50 on which is deposited a pair of resistor tracks 52,53. The relays 24 comprise the seven relays 54-66 and the fuses 28 comprise a pair of fuses 68,70 all of which are mounted on the board 50. The electrical connectors 26 comprise the connectors H for connection with the vehicle wiring harness (not shown), a connector B for connection to the vehicle battery (not shown), a connector 72 for connection to the vehicle's electrical earth, connectors 74 for connection with the temperature and pressure sensors, and connectors 76,78 for supplying power to a pair of motors associated with a radiator fan. The interconnections between the relays, fuses and electrical connectors may be made on the other side of the board 50. An example of these interconnections is shown in Figure 4 in which like parts have been given the same reference numerals. The circuit diagram of Figure 4 also shows the relative connections to the temperature sensors 80,82, the pressure sensors 84, and to each motor 86,88. It will be apparent from Figure 4 that the motor 86,88 which is selected to operate and the level of power supplied to that motor (that is, the speed of the motor) is dependent on the signals from the temperature sensors 80,82 and the pressure sensors 84 which close their respective switches at different levels of temperature and pressure respectively. Motor 86 drives a radiator fan to push air through a radiator and motor 88 drives a radiator fan to pull air through a radiator.

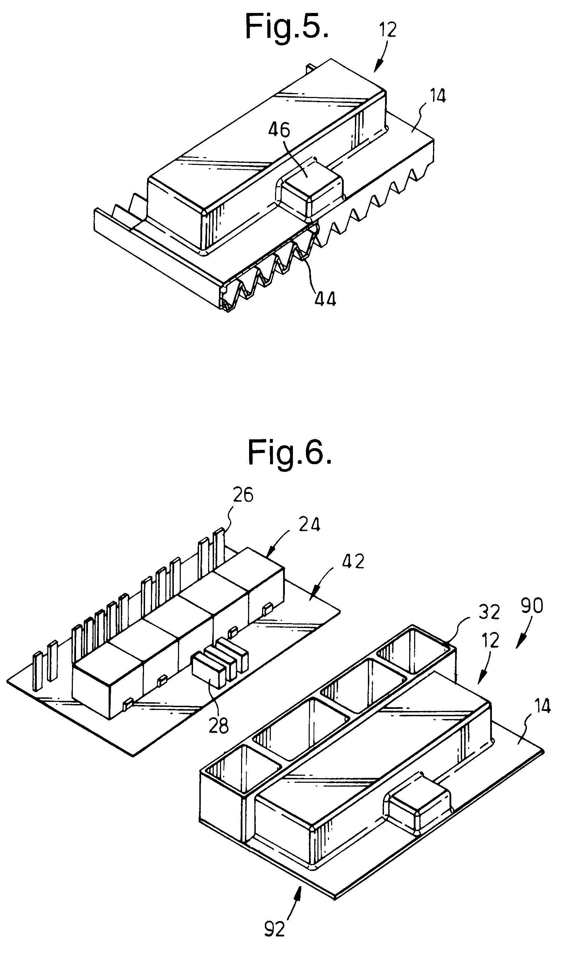

In the modification of the control module 40 of Figure 2, as shown in Figure 5, the second part 16 of the housing 12 is omitted, and the heat sink 44 also acts as part of the housing 12.

The third embodiment of control module 90 shown in Figure 6 is similar to the control module 40 of Figure 2, and like parts have been given the same reference numeral. In this embodiment, the heat sink and the housing duct are omitted and the housing 12 and connector housing 32 are formed in one piece. The housing 12 is defined by the first part 14 only and is open at its lower side 92. This open side 92 is closed on assembly of the control module 90 by the combined element 42. In this embodiment, the combined element 42 acts as the heat dissipating means and dissipates heat to air passing across the underside of the combined element 42.

The portion of the housing 12 which surrounds the fuses 28 may include a removable door 46 (Figure 5) which would allow external access to the fuses 28 without dismantling the whole control module. The housing may, alternatively, be metallic to enhance the heat dissipating means, or to act as the heat dissipating means. These features are applicable to any of the described embodiments of control module.

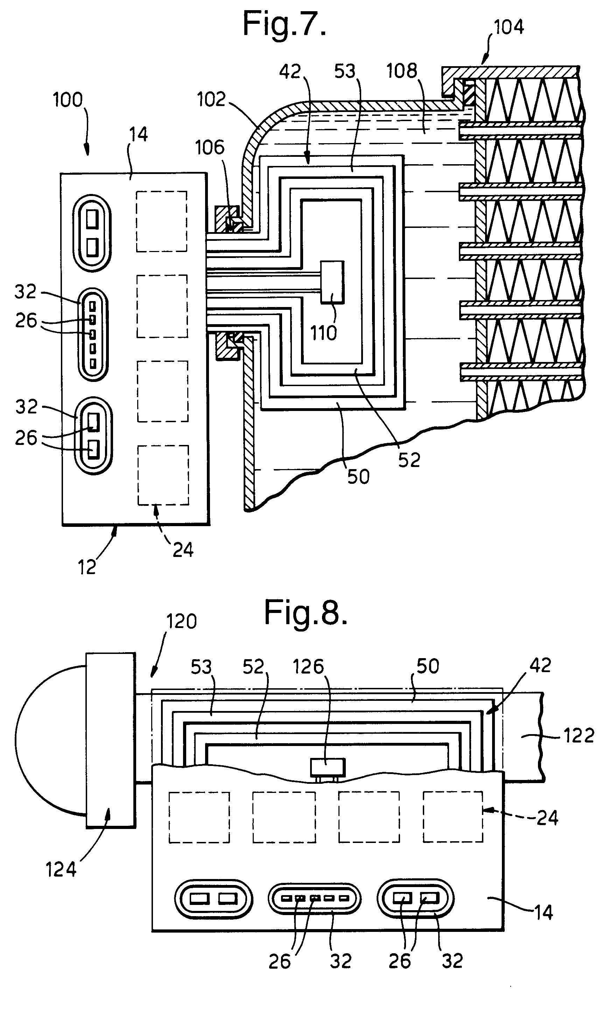

The fourth embodiment of control module 100 shown in Figure 7 is similar to the control module 90 of Figure 6, and like parts have been given the same reference numeral. In this embodiment, the control module 100 is fastened to the header or manifold 102 of a radiator 104. The alumina board 50 of the element 42 extends through an aperture 106 in the header 102 and is sealed therein. The resistor tracks 52,53 extend across the alumina board 50 inside the header 102. The coolant fluid 108 within the header 102 acts as the heat dissipating means for the control module 100. One or more temperature sensors 110 may be mounted on the alumina board 50 inside the header 102 and be directly connected with the electrical circuitry of the control module 100.

The fifth embodiment of control module 120 shown in Figure 8 is similar to the control module 90 of Figure 6, and like parts have been given the same reference numeral. In this embodiment, the control module 120 is fastened directly to a flat surface 122 of the radiator 124 of the vehicle or to a heat exchanger of the air conditioning system in the vehicle, with the open (lower) side of the housing 12 in direct contact with the flat surface. The housing 12 has been cut away to show that the resistor tracks 52,53 on the alumina board 50 lie above the flat surface 122, the flat surface thereby acting as heat dissipating means for the control module 120. One or more temperature sensors 126 may be mounted on the alumina board 50 inside the housing 12 and above the flat surface 122, and be directly connected with the electrical circuitry of the control module 120.

## Claims

1. A control module (10) for a radiator fan comprising a housing (12); a thick film circuit (20) at least partially covered by the housing and having at least one resistor formed thereon; a number of relays (24) covered by the housing; electrical circuitry means (22) covered by the housing and electrically interconnecting the resistors and the relays; heat dissipating means (30); and electrical connectors (26) for providing input power to the electrical circuitry means and for providing control signals to the radiator fan.

2. A control module as claimed in Claim 1, wherein the thick film circuit (20) comprises a board of insulating material onto which the resistors have been formed.

3. A control module as claimed in Claim 2, wherein the insulating material is alumina.

4. A control module as claimed in any one of Claims 1 to 3, wherein the thick film circuit and the electrical circuitry means are integrally formed (42).

5. A control module as claimed in Claim 4, wherein the relays (24) and the electrical connectors (26) are mounted on the integrally formed thick film circuit and electrical circuitry means (42).

6. A control module as claimed in any one of Claims 1 to 5, wherein the heat dissipating means is a metallic heat sink (44) attached to the thick film circuit.

7. A control module as claimed in any one of Claims 1 to 5, wherein the thick film circuit (42) extends into a header or manifold (102) of a radiator (104), and wherein coolant fluid within the header or manifold acts as the heat dissipating means.

8. A control module as claimed in any one of Claims 1 to 5, wherein the control module (120) is secured directly to a substantially flat surface (122) of a radiator (124), and wherein the flat surface acts as the heat dissipating means.

9. A control module as claimed in any one of Claims 1 to 3, wherein the electrical circuitry means (22) is mounted on the thick film circuit (20) by way of substantially rigid metallic posts (30) which provide electrical interconnections between the resistors and the electrical circuitry means and which act as the heat dissipating means.

10. A control module as claimed in any one of Claims 1 to 9, wherein the electrical connectors (26) are positioned within a connector housing (32) secured to the housing (12).

11. A control module as claimed in any one of Claims 1 to 10, wherein the electrical circuitry means (22) includes at least one fuse (28).
